Europäisches Patentamt

European Patent Office

Office européen des brevets

(19)

(11) Publication number: 0 278 599
A2

# (12) EUROPEAN PATENT APPLICATION

(21) Application number: 88300351.9

(22) Date of filing: 18.01.88

(51) Int. Cl.⁴: G03B 27/32

(30) Priority: 02.02.87 JP 22006/87
03.03.87 JP 48275/87
30.04.87 JP 107702/87

(43) Date of publication of application:
17.08.88 Bulletin 88/33

(84) Designated Contracting States:
DE FR GB

(71) Applicant: SEIKO EPSON CORPORATION
4-1, Nishishinjuku 2-chome
Shinjuku-ku Tokyo-to(JP)

(72) Inventor: Kobayashi, Atsushi c/o Seiko Epson
Corp.
3-5, Owa 3-chome
Suwa-shi Nagano-ken(JP)
Inventor: Suzuki, Takashi c/o Seiko Epson
Corp.
3-5, Owa 3-chome
Suwa-shi Nagano-ken(JP)
Inventor: Kosugi, Yasuhiko c/o Seiko Epson
Corp.
3-5, Owa 3-chome
Suwa-shi Nagano-ken(JP)

(74) Representative: Miller, Joseph et al
J. MILLER & CO. Lincoln House 296-302 High
Holborn
London WC1V 7JH(GB)

(54) Photographic transfer type image forming apparatus.

(57) A photographic transfer type image forming apparatus comprising support means (114,115) for supporting a photosensitive member (120) which carries capsules (502) containing a photo-setting substance and a colour developing agent; exposure means (200), including illuminating means (210), for exposing an image forming region (721) of the photosensitive member (120) to light from an original (140) which is to be copied, so that the photosensitive member (120) is provided with a latent image in the image forming region (721); and developing means (300) for transferring the latent image to a transfer member (130) so as to form an image on the latter characterised in that the exposure means (200) comprises uniform exposure means (260) for subjecting the image forming region (721) to uniform exposure.

Fig. 2.

## "PHOTOGRAPHIC TRANSFER TYPE IMAGE FORMING APPARATUS"

The present invention relates to a photographic transfer type image forming apparatus designed to form an image on a photosensitive member by light exposure and to transfer the image formed on the photosensitive member to another member as a developed image.

There are known two different types of image forming apparatus wherein an image is formed on a photosensitive member by light exposure to thereby obtain an image output, that is, the electrophotographic type and the silver halide photographic type.

These image forming apparatus suffer, however, from the following disadvantages and therefore cannot meet users' requirements.

Namely, the electrophotographic type image forming apparatus suffers from an inferior intermediate tone reproducibility, which is characteristic of this type of apparatus. Thus in the case of a colour image forming apparatus, exposure and transfer as well as fixing of a colour toner are effected for each of three colours, i.e. yellow, magenta and cyan (hereinafter referred to as "Y, M and C"). Therefore, it is necessary, in order to prevent undesirable offset of images which are formed for each of the colours, to transport the sheet of paper which is to carry the copy with a high degree of accuracy and this leads to an increase in size and cost of the apparatus. Further, it is difficult to obtain a clear duplicated image because of the undesirable offset of colours.

On the other hand, the silver halide photographic type copying machine has the following basic problems which arise from the fact that a wet process must be carried out in this type of apparatus. Namely, it is not easy to handle the apparatus, and it is necessary to dispose of waste liquid which gives off a nasty smell. In addition, since a photographic paper which uses silver is employed, the running cost is disadvantageously high. Further, since the developing process needs complicated steps, a large-scale system is required, which results in increases in both weight and size of the apparatus. The production cost is also raised.

In the case of the electrophotographic type apparatus, a photosensitive member having a latent image formed thereon and a transfer member are laid one upon the other and these members are subjected to pressure development to thereby form either a colour or a monochromatic image on the transfer member.

The photosensitive member may have microcapsules having a diameter of several μm uniformly distributed over the surface of a substrate, the micro-capsules containing dye precursors which react with a developer (described later) to develop colours and photo-setting substances which react only with light within wavelength regions corresponding to three colours, i.e. red, green and blue (hereinafter referred to as "R, G and B") so as to effect setting. On the other hand, the transfer member has on its surface a developer which reacts with each of the dye precursors for R, G and B to develop these colours. Accordingly, when a colour image is formed on the photosensitive member by light exposure, the photo-setting substances in the micro-capsules which correspond to the respective wavelengths are hardened in accordance with the intensity of light. Therefore, when the transfer member and the photosensitive member which are laid one upon the other with their surfaces brought into contact with each other are pressed, the micro-capsules which are left unhardened are crushed in accordance with the quantity of light received. Thus, the dye precursors in the crushed micro-capsules react with the developer on the transfer member to form a colour image.

Since the three different kinds of micro-capsule, i.e. those which are for R, G and B, are exposed simultaneously, it is necessary to effect exposure only once with light rays having the above-described wavelengths. Further, since each micro-capsule has a diameter of several μm, the resulting colour image can have a high resolution, i.e. about 100 dots/mm. In addition, the production cost of paper used in such apparatus is very low in comparison with that of the photographic paper used in the silver halide photography, and it is advantageously possible to effect development by a dry process.

Although this image forming method exhibits the above-described various advantages, it still has the following previously unsolved problems.

The first problem is that the dynamic range with respect to the exposure energy is small. More specifically, in the relationship between the exposure energy and the colour development density (OD value), the range of exposure energy levels for colour development at intermediate densities which is shown by an intermediate tone region is relatively small. Therefore, when energy levels of the original image for exposure are distributed over a wide range, gradation cannot sufficiently be reproduced.

The second problem is that hues are not readily reproduced with high fidelity because the maximum and minimum effective exposure quantities depend upon the wavelength of the exposure light.

The third problem is that, since a region on the surface of the photosensitive member other than the image forming region is not exposed, when the photosensitive member laid on the transfer member is subjected to pressure development, the micro-capsules in this unexposed region are crushed to cause unnecessary colour development on the transfer member, resulting in the external appearance of the transfer member being considerably degraded. Further, the liquid component flowing out from the crushed micro-capsules cause the transfer and photosensitive members to adhere to each other, which makes it difficult to separate them from each other in the subsequent separating step. When the above-described unexposed region of the photosensitive member which is not covered with the transfer member is pressed by a pair of rollers of the pressure developing device, the contents of the unset micro-capsules on the photosensitive member adhere to the rollers or other elements, resulting in the device being damaged. To prevent this problem, it may be effective practice to press the transfer and photographic members with a pair of rollers of the pressure developing device only when the transfer member is present between the rollers and to separate the rollers from each other when the transfer member is not present therebetween. This method suffers, however, from the problem that the leading and trailing edge portions of the transfer member are not pressed and, since the pressing operation is carried out with a pair of cylindrical rollers, the boundaries at the leading and trailing edge portions of the transferred image become blurred, resulting in an unattractive image.

According, therefore, to the present invention, there is provided a photographic transfer type image forming apparatus comprising support means for supporting a photosensitive member which carries capsules containing a photo-setting substance and a colour developing agent; exposure means, including illuminating means, for exposing an image forming region of the photosensitive member to light from an original which is to be copied,so that the photosensitive member is provided with a latent image in the image forming region; and developing means for transferring the latent image to a transfer member so as to form an image on the latter characterised in that the exposure means comprises uniform exposure means for subjecting the image forming region to uniform exposure.

The exposure means preferably also comprises further exposure means for effecting exposure of the regions of the photosensitive member adjacent to the image forming region.

The developing means preferably comprises means for effecting pressure contact between the photosensitive member and the transfer member.

The exposure means may comprise an exposure member which reflects or scatters the light emitted from said illuminating means when said photosensitive member is being exposed.

The exposure member may be arranged so that various portions thereof have different reflectivities or light scattering coefficients.

The uniform exposure means may comprise adjustment means which enables the uniform exposure quantity with respect to said photosensitive member to be changed.

The uniform exposure means may comprise means which enables the uniform exposure quantity to be changed in accordance with temperature and humidity.

The uniform exposure means may employ as light for the uniform exposure direct or indirect light emitted from said illuminating means.

The uniform exposure means may employ as a light source for the uniform exposure an auxiliary light source which is used exclusively for the uniform exposure.

Preferably the auxiliary light source for the uniform exposure has spectral components in at least three different wavelength regions.

The uniform exposure means may employ a plurality of different uniform exposure quantity compensating filters.

The exposure means may have a colour adjusting means which comprises a colour temperature compensating filter for effecting colour temperature compensation of direct or indirect light emitted from said illuminating means and colour adjusting filter means for effecting colour adjustment.

The colour adjusting filter means may comprise three different filters, and further filters which transmit substantially all visible rays and each of which has substantially the same thickness as that of each of the three different filters.

The further exposure means preferably effects exposure using direct or indirect light emitted from said illuminating means.

The exposure means may have an auxiliary light source which is exclusively used to expose a region adjacent to the image forming region.

The invention also comprises a photographic transfer type image forming apparatus comprising support means for supporting a photosensitive member which carries capsules containing a photo-setting substance and a colour developing agent; exposure means, including illuminating means, for exposing an image forming region of the photosensitive member to light from an original which is to be copied, so that the photosensitive member is provided with a latent image in the image forming region; and developing means for transferring the latent image to a transfer member so as to form an image on the latter characterised in that the exposure means comprises further exposure means for effecting exposure of the regions of the photosensitive member adjacent to the image forming region.

The invention is illustrated, merely by way of example, in the accompanying drawings, in which:-

Figure 1 is a sectional front view of one embodiment of a photographic transfer type image forming apparatus according to the present invention;

Figure 2 is a sectional front view of an exposure means employed in the photographic transfer type image forming apparatus of Figure 1;

Figure 3 is a schematic perspective view showing the function of an image forming means comprising a self focussing lens group forming part of the structure shown in Figure 2;

Figure 4 is a sectional front view similar to that of Figure 2 but showing an alternative exposure means;

Figure 5 is a schematic sectional view of an example of a colour adjusting means which may form part of an apparatus according to the present invention;

Figure 6 is a perspective view of a colour filter plate forming part of the struture shown in Figure 5;

Figure 7 is a sectional view showing the junction of a colour adjusting filter and a transparent glass which are shown in Figure 5;

Figure 8 schematically shows the function of an exposure plate forming part of the apparatus of Figure 2;

Figure 9 is a block diagram showing one example of a uniform exposure quantity control system which may be used in an apparatus according to the present invention;

Figure 10 is a sectional front view of another example of a uniform exposure system which may be used in an apparatus according to the present invention;

Figure 11 is a sectional front view of a further example of a uniform exposure system which may be used in an apparatus according to the present invention;

Figure 12 is a sectional front view of an example of a means for exposing regions other than an image forming region;

Figure 13 shows a top plan view and a side elevation of another example of a means for exposing regions other than the image forming region;

Figure 14 is a sectional front view of a further example of a means for exposing regions other than the image forming region;

Figure 15 is a schematic view employed to illustrate the operation of the mechanism shown in Figure 14;

Figures 16 and 17 are graphs showing the relationship between the exposure energy and the density wavelength in relation to the photosensitive and transfer members which may be employed in an image forming apparatus according to the present invention, and

Figures 18 and 19 are graphs showing the effects attained by practicing uniform exposure.

Terms such as "upper" and "lower" as used in the description below, are to be understood to refer to directions as seen in the accompanying drawings.

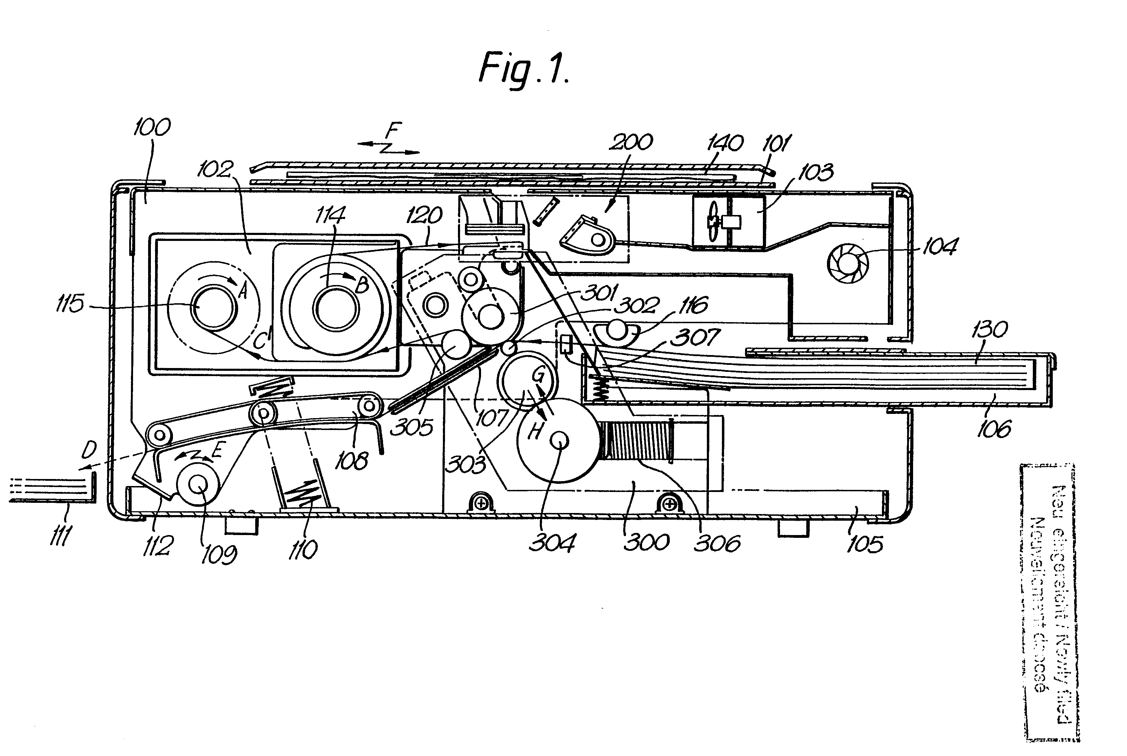

Figure 1 is a sectional view showing the basic arrangement of one embodiment of an image forming apparatus according to the present invention in which the invention is applied to a copying machine. The copying machine in accordance with this embodiment is of the moving original exposure type having a clamshell structure in which upper and lower frames 100, 105 are pivotally connected together in such a way that the upper frame 100 may be opened. On the upper frame 100 are mounted an original plate 101, a photosensitive member cassette 102, an exposure optical system 200, air-cooling fans 103, 104, an upper press roller 301 and a pressure roller 305 which constitute a part of a pressure developing means 300. On the lower frame 105 are mounted a transfer member cassette 106, a separating device 107, a heat-treating means 108, a pivot shaft 109, a spring 110, and an intermediate press roller 302, a lower press roller 303, a force application shaft 304, a force application spring 306 and a detector 307 which constitute the other part of the pressure developing means 300, together with an output image tray 111.

The upper frame 100 is engaged with the pivot shaft 109 so that the upper frame 100 can be pivoted in the directions of an arrow E shown in Figure 1. When the upper frame 100 is to be pivotally moved upwards, it is pushed up by means of the force from the spring 110 until a foot portion 112 of the upper frame 100 abuts against the bottom portion of the lower frame 105, whereby the upper frame 100 is supported and maintained in an open state. A photosensitive member 120, which is in the form of a continuous belt, is stretched between a supply shaft 114 and a take-up shaft 115 and is fed in the direction of an arrow C' shown in Figure 1. Transfer members 130 are in the form of sheets cut into a predetermined uniform size and are stacked within the transfer member cassette 106. The original plate 101 with an original 140 placed thereon is movable in the directions of an arrow F shown in Figure 1.

The function of each of the constituent elements will be described below in accordance with the image forming process. To form an image, the original 140 is first set at a predetermined position on the original plate 101. Then, the original plate 101 moves to a start position and stops thereat for a moment and then moves again. At the same time, the supply shaft 114 rotates in the direction of an arrow B shown in Figure 1, and the take-up shaft 115 rotates in the direction of an arrow A, so that a length of the photosensitive member 120, which corresponds to a desired size of an image to be formed, is advanced at the same speed as the speed of movement of the original plate 101 so as to pass over an exposure plate of the exposure optical system 200.

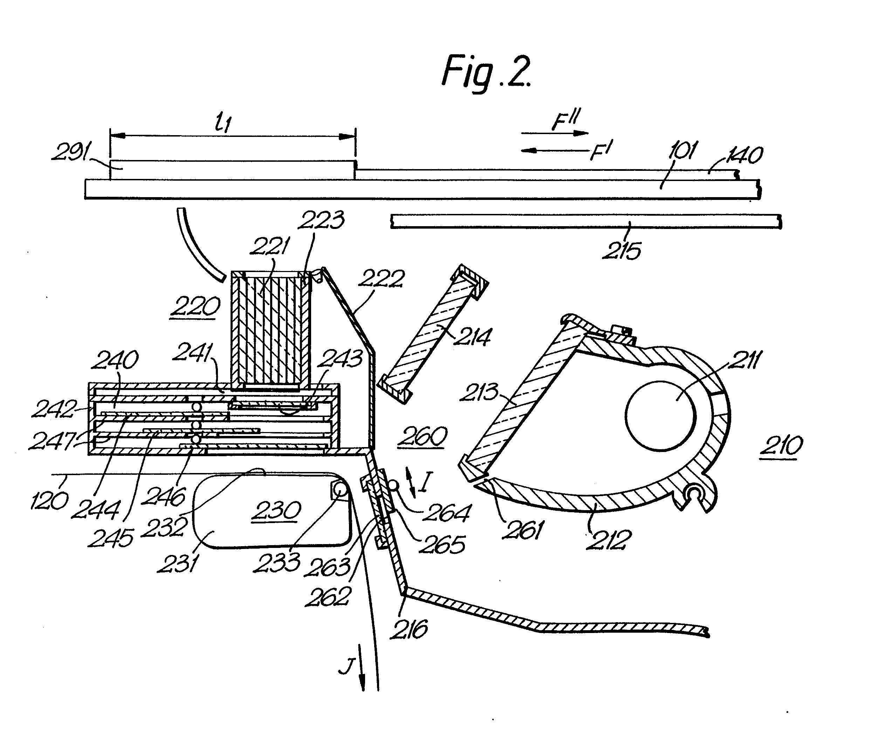

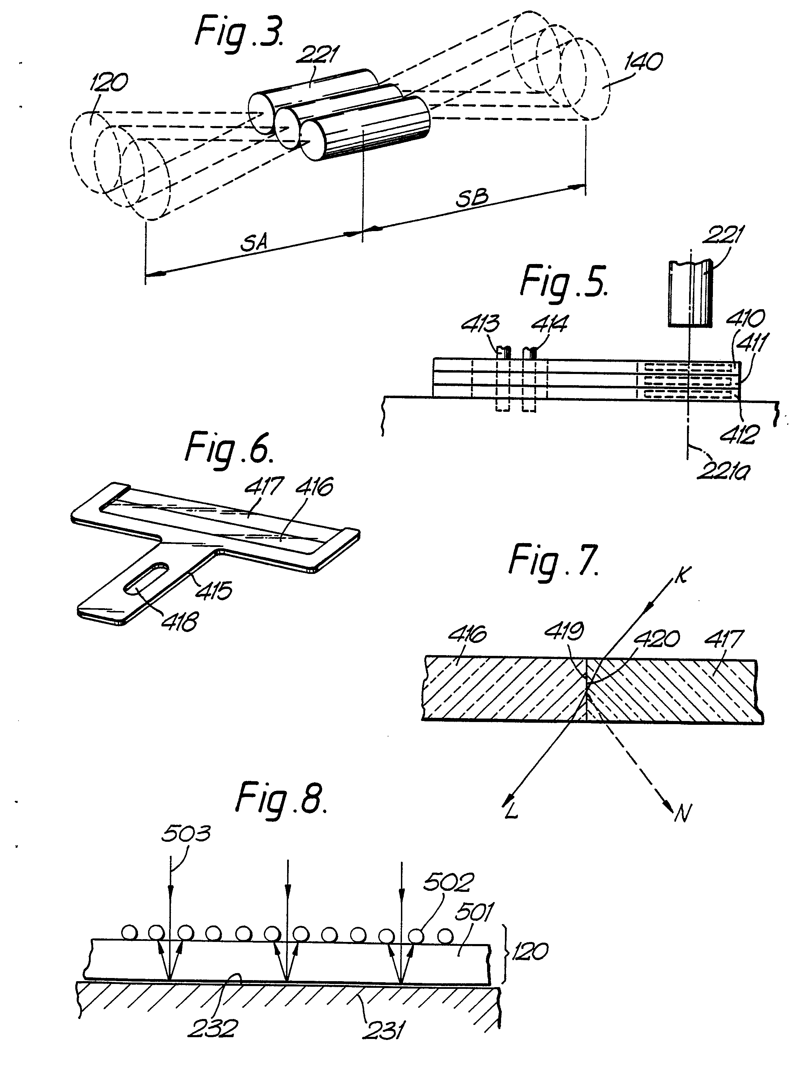

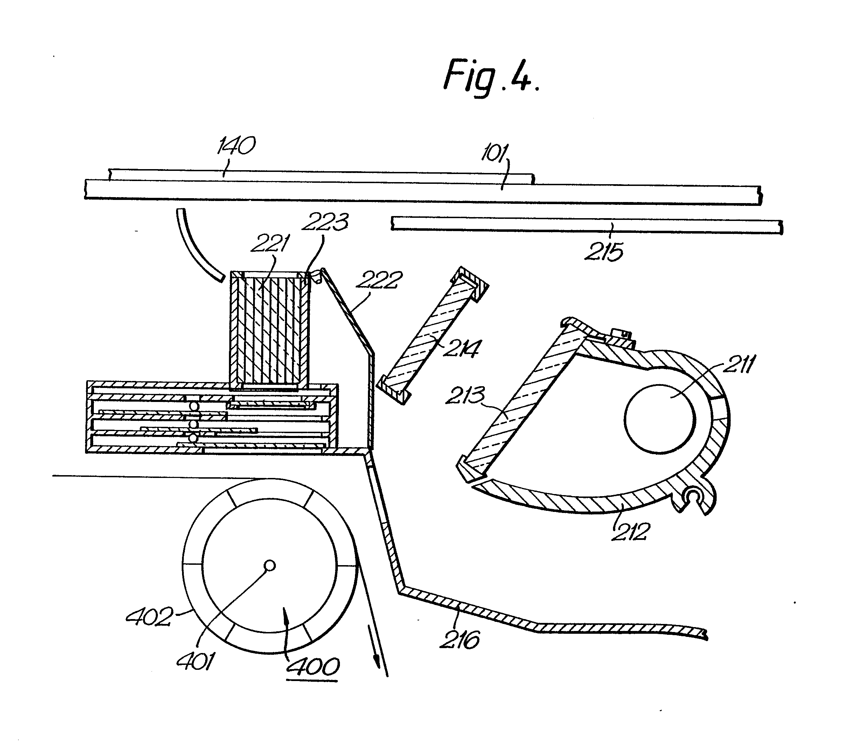

When the original 140 and the photosensitive member 120 are passing over an exposure plate 231 (Figure 2) at an even speed, light from a halogen lamp 211 is condensed by a reflector 212; is passed through a heat ray reflecting shutter which is provided in order to improve the ventilation effected by the air-cooling fans 103,104 and also to effect partial reflection of the heat energy from the halogen lamp 211; is further passed through a heat ray absorbing filter 214 which is so disposed as to prevent the heat energy from the halogen lamp 211 from being applied directly to the original 140; and is then applied to the original 140 to illuminate it. The reflected light from the original 140 is passed through an image-forming lens system 220 and a compensating filter unit to effect partial formation of the image of the original 140, thereby successively exposing the photosensitive member 120. In this way, the whole surface of a predetermined region of the photosensitive member 120 is exposed and the transferability of transfer material carried by the photosensitive member 120 is thereby controlled.

The uppermost sheet in the stack of transfer members 130 is drawn out by the action of a pick-up roller 116 in the course of the exposure of the photosensitive member 120 and is transported by means of a transport system in the direction of an arrow D in Figure 1 so that the transfer member 130 is laid on the exposed photosensitive member 120. The photosensitive member 120 and the transfer member 130 which are laid one upon other in one unit are led into the pressure developing means 300. Immediately after the detector 307 detects the fact that the leading edge of the transfer member 130 is fed into the area between the upper and intermediate press rollers 301 and 302, pressure development is started, and immediately before the trailing edge of the transfer member 130 comes out of the area between the press rollers 301 and 302, and roller 302 moves downwards to release the transfer member 130 from the pressure. The intermediate press roller 302 that has a relatively small diameter is in contact with the lower press roller 303 and is thereby backed up so that deformation of the intermediate press roller 302 is resisted. When the pressure development is not carried out, the intermediate press roller 302 is moved downwards to define a spacing between the same and the upper press roller 301.

Since a predetermined level of pressure is needed to crush micro-capsules which are carried by the photosensitive member 120, it is preferable to make the diameter of the intermediate press roller 302 smaller than that of the upper press roller 301 in order to reduce the area of the pressing surface of the roller 302 and to thereby increase the level of pressure.

The exposed photosensitive member 120 is laid on the transfer member 130 which is moving in the direction of the arrow D and these members 120 and 130 are pressed between the upper and intermediate press rollers 301 and 302. At this time, since the intermediate press roller 302 has a relatively small diameter, it is difficult to ensure that the leading edge of the transfer member 130 is received into the area between the upper and intermediate press rollers 301 and 302. For this reason, the intermediate press roller 302 is moved towards and away from the upper press roller 301 through the action of the lower press roller 303 by the action of a driving mechanism (not shown).

When no transfer member 130 is inserted into the area between the upper and intermediate press rollers 301 and 302, the intermediate press roller 302 is spaced apart from the upper press roller 301. Immediately after the leading edge of the transfer member 130 is fed into the area between the upper and intermediate press rollers 301 and 302, the intermediate press roller 302 is moved in the direction of an arrow G through the action of the lower press roller 303 so as to hold and press the transfer and photosensitive members 130 and 120 in cooperation with the upper press roller 301 and, in this state, the rollers 301 and 302 rotate to advance the transfer and photosensitive members 130 and 120. Thus, an image coloured by means of dye precursors in the capsules which have been crushed on the photosensitive member 120 is transferred to the transfer member 130. Immediately before the leading edge of the transfer member 130 comes out of the area between the upper and intermediate press rollers 301 and 302, the intermediate press roller 302 is moved in the direction of an arrow H through the lower press roller 303 to await a subsequent transfer member 130 which is to be inserted.

The photosensitive and transfer members 120 and 130 coming out of the pressure developing means 300 are separated from each other by means of the separating device 107 that utilizes a separating member made of a resin material. Then, the transfer member 130 is passed through the heat-treating means 108 which has a heating section which is provided in order to promote the formation of the image and stabilize the formed image as well as to improve the quality of the image. The transfer member 130 is then discharged to the output image tray 111. The photosensitive member 120 thus used is passed through the area between the upper press roller 301 and the pressure roller 305 and is then transported in the direction of the arrow C. The rotation of the take-up shaft 115, which is provided within the photosensitive member cassette 102, is suspended when the trailing edge of the transfer member 130 comes out of the area between the upper and intermediate press rollers 301 and 302. Thus, one cycle for forming one image output is completed, and images are successively formed by repeating the above-described cycle.

The exposure optical system 200, which constitutes an exposure means of the present invention, will next be explained in detail.

Referring to Figure 2, which is a schematic sectional front view of the exposure optical system 200, the system 200 consists essentially of the following six sections, that is, an illuminating means 210, the image-forming lens system 220, a colour adjusting means 240, exposure means 230 comprising the exposure plate 23, a uniform exposure means 260 and an exposure means, constituted by a white plate 291, for exposing regions other than the image forming region. The way in which exposure of an image is effected by the illustrated exposure optical system 200 will be briefly explained.

A correct actual size real image of the original 140 which is illuminated by the illuminating means 210 (described later) is formed on the surface of the photosensitive member 120 by means of a self-focusing lens group 221 which constitutes the image-forming lens system 220. In the exposure optical system 200 in accordance with this embodiment, a correct actual size real image is formed by means of the self-focusing lens group 221. The surface of the original 140 which is placed on the original plate 101 and the surface of the photosensitive member 120 are disposed at optically equal distances with respect to the self-focusing lens group 221. The original 140 and the photosensitive member 120 are moved in the same direction at the same speed, thereby enabling the whole surface of the original 140 to be scanned and thus exposing the photosensitive member 120 so that the whole image of the original 140 is formed on the member 120.

The halogen lamp 11 is in the form of a straight tube which has a colour temperature of 3000°K to 3200°K and a rated power of 800 W. The reflector 212 has a substantially semi-elliptical cross-sectional configuration so that the reflector 212 partially covers the halogen lamp 211 to enable visible rays of light emitted from the halogen lamp 211 to reach the original 140 efficiently.

Among the rays of light emitted from the halogen lamp 211 are visible rays which are condensed so as to illuminate the original 140, while infra-red rays are reflected and absorbed by a heat ray reflecting filter 213 and the heat ray absorbing filter 214, respectively, which are mounted midway in the optical path to the original illuminating position.

It should be noted that the reference numeral 215 denotes an upper frame of the illuminating means 210.

The transparent original plate 101 is arranged such that, when the original plate 101 is moved in the direction of the arrow F′ with the original 140 placed thereon, scanning of the original 140 is effected, and when the scanning is completed, the original plate 101 is moved in the direction of the arrow F″ to return to the stand-by position shown in Figure 2.

In this embodiment, the self-focusing lens group 221 constituting the image-forming lens system 220 is composed of eight rows of self-focusing lenses, each row consisting of about 120 elements which are arranged in a direction perpendicular to the direction of movement of the original plate 101 so that it is possible to effect exposure for originals having a size of $210 \times 297$ mm. The self-focusing lens group 221 is rigidly secured to a self-focusing lens securing frame 223 which, in turn, is rigidly and tightly secured to a light-shielding plate 222 having its inner side surfaces painted black so as to prevent reflection. The self-focusing lens group 221 is a lens system which forms a correct actual size real image at a distance $S_A = S_B$ as shown in Figure 3. In Figure 3, the reference numeral 140 denotes the surface of the original, while the numeral 120 denotes the surface of the photosensitive member.

Since the self-focusing lens group 221 consists of eight rows of elements as described above, it is theoretically possible to obtain a quantity of light which is eight times that in the case of a self-focusing lens group consisting of a single row of elements, and it is therefore possible to reduce the quantity of light required from the light source. However, if the number of rows of the self-focusing lens group 221 is ten or more, no further enhanced effectiveness is obtained since in such a case the outermost row of the resultant self-focusing lens group is out of the range of illumination by the rays of light emitted from and condensed by the illuminating means 210.

A detecting roller 233 is rotatably supported in the right upper corner of the exposure plate 231 so that the detecting roller 233 is in close contact with the photosensitive member 120 and rotates by an amount corresponding to the amount of feed of the photosensitive member 120. A rotary encoder (not shown) is attached to one end of the detecting roller 233 for the purpose of detecting the amount of rotation of the detecting roller 233.

A light-shielding plate 241 (described below) for shielding the rays of light from the image-forming lens system 220 is disposed under the lens system 220 and on the upper surface of a filter casing 242 (described later) so that the light-shielding plate 241 is slidable sidewards as viewed in Figure 2. The light-shielding plate 241 can be selectively moved by the action of a plunger (not shown) either to a position where it allows the said rays of light to pass or to a position where it intercepts the light.

The following is a description of the exposure plate 231.

Referring to Figure 2, the exposure plate 231 is disposed at the above-described distance from the self-focusing lens group 221. The exposure plate 231 may be made of a white plastics plate which is not subject to deformation so that it is adapted to reflect the exposure light passing through the photosensitive member 120. The surface 232 of the exposure plate 231 is provided with a multiplicity of grooves slightly slanted in the direction of advance of the photosensitive member 120 in order to prevent generation of feed failures of the photosensitive member 120 due to close contact of the member 120 with the surface 232.

Although in this embodiment a white plastics plate is employed as the exposure plate 231, other constructions are possible. Thus, for example, a metal plate such as an aluminium plate or a surface reflecting mirror having a reflecting mirror defined by the surface 232 may also be employed as the exposure plate 231. It is also possible to employ an irregular reflection plate which is formed by coating a satin-finished surface of a plastics or metal plate with a metal, e.g. aluminium, by evaporation, plating or the like, and protecting the coated surface with a transparent material.

The reason why the surface of the exposure plate 231 is formed so as to serve as a reflecting surface is that it is intended to reflect the exposure light passing through the photosensitive member 120 in order to use the reflected light as effectively as possible for the exposure. This will be briefly explained with reference to Figure 8.

Referring to Figure 8, the photosensitive member 120 is transparent or semi-transparent and consists of a substrate 501 and micro-capsules 502 formed on the substrate 501. The support surface 232 of the exposure plate 231 is formed so as to reflect light. When light rays 503 are applied in the directions of the arrows from the upper side as viewed in Figure 8, the micro-capsules 502 are irradiated not only with direct light rays but also with the light rays passing through the photosensitive member 120 and reflected from the support surface 232. Accordingly, it is possible to increase the quantity of light applied to the micro-capsules 502.

Thus, employment of such an exposure plate 231 enables formation of an image of high quality without the need to increase the light output from the halogen lamp 211 serving as a light source for exposure and without the need to increase the exposure time.

Another example of an exposure member, which may be used instead of the exposure plate 231, will next be explained with reference to Figure 4. The exposure member 400 in this example is arranged such that it can be rotated as desired by rotating its central shaft 401 by the operation of a driving means such as a motor or the like. However, when exposure is being carried out, the exposure member 400 is held at rest. In this example, the exposure member 400, which is in the shape of a cylinder, is divided into six portions having different surface conditions. For example, the surface 402 of the first of the six divided portions is a m rror surface; the surfaces 402 of the second to fifth portions have reflectivities of 80%, 60%, 40% and 20%, respectively; and the surface 402 of the sixth portion is painted black so as to reflect no light. Accordingly, it is possible to change the level of quality of an image to be formed by rotating the exposure member 400 so as to select a desired reflectivity and effecting exposure using the selected portion of the exposure member 400.

The colour adjusting means 240 will next be explained.

Referring to Figure 2, the colour adjusting means 240 comprises a compensating filter unit 240 which is disposed below the light-shielding plate 241. A colour temperature compensating filter 243 is retained by the inner wall surfaces of the uppermost portion of the filter casing 242 which is made of a black resin material and which is disposed so as to mask the whole of the optical path in a normal state of use.

The colour temperature compensating filter 243 consists of one or more filters. A primary object of the filter 243 is to compensate for the spectral distribution of the light from the light source 211 in accordance with the sensitivity of the photosensitive member 120 employed.

In this embodiment, the colour temperature compensating filter 243 is a dichroic filter which partially reflects rays of light in a long-wave region of about 500 nm or more. The term "dichroic filter" is employed herein to mean a filter which is formed by evaporating an interference film on the surface of a transparent or semi-transparent member, e.g. transparent glass or coloured glass, so that the filter is capable of selectively transmitting or reflecting light within a specific wavelength region.

Since the light which is applied to the original 140 has a particular spectral distribution in accordance with the characteristics of the halogen lamp 211, the heat ray reflecting filter 213 and the heat ray absorbing filter 214, the spectral distribution must be compensated for in accordance with the sensitivity of the photosensitive member 120 in order to develop colours close to those of the image of the original 140. This compensation is effected by the colour temperature compensating filter 243.

It should be noted that delicate adjustment of the spectral distribution or compensation for a change in the spectral distribution due to deterioration of the halogen lamp 211, which cannot satisfactorily be effected by the colour temperature compensating filter 243 alone, is carried out by means of three different kinds of colour adjusting filters (i.e. a yellow filter 244, a magenta filter 245 and a cyan filter 246).

Figure 5 is a side view of another example of a colour adjusting means which constitutes a part of the present invention. The colour adjusting means in accordance with this example consists of three filter plates 410, 411, 412, guide pins 413, 414 for guiding the movement of these filter plates, and a lever (not shown) for moving the filter plates 410, 411 and 412 independently of each other.

Figure 6 is a perspective view of one filter plate. Each filter plate consists of a support member 415, a colour adjusting filter 416 and a transparent glass 417. The support member 415 is provided with a slot 418 which is engageable with the guide pins 413, 414. The guide pins 413, 414 are rigidly secured to a chassis, and the position of the guide pins 413, 414 relative to the self-focusing lens group 221 is fixed. When the said lever is moved, the support member 415 is moved perpendicularly to the central axis 221a of the self-focusing lens group 221 while being guided by the combination of the slot 418 and the guide pins 413, 414.

Figure 7 shows the positional relationship between the self-focusing lens group 221 and the colour adjusting filter 416. In this example also, the colour adjusting filter 416 is supported by the support member 415 so its end face 419 extends parallel to the central axis 221a of the self-focusing lens group 221. Since the support member 415 moves perpendicularly to the central axis 221a, the end face 419 of the colour-adjusting filter 416 is always parallel to the central axis 221a of the self-focusing lens group 221.

Each individual filter must be arranged so that insertion of the filter has no effect on the effective optical path length. If the effective optical path length is affected, the resulting image may be distorted and, at the same time, the resolution may be lowered, which results in the quality of the image being degraded to a considerable extent. In this example, three transparent plate glasses (not shown) which correspond to the transparent glass 417 are provided in advance in that portion of the optical path where the filters 416 are to be inserted, thereby eliminating the possibility of the optical path length being changed. In the case where the change in the optical path length caused by insertion of the filters 416 is within the focal depth of the self-focusing lens group 221 as in the case of the above-described example in which sufficiently thin filters are employed, it is unnecessary to provide the transparent glasses. The thickness of the transparent glass 417 is set so that the glass 417 has the same optical path length as that of the filter.

Figure 7 shows the junction of the colour adjusting filter 416 and the transparent glass 417 as viewed from one side thereof. The end faces of the colour adjusting filter and the transparent glass are generally simple cut surfaces, and in such a case, since simple cut surfaces regularly reflect rays of light, light which is incident on the junction of the filter 416 and the glass 417 in the direction of the arrow K in Figure 7 travels not only in the direction of the arrow L thereof but also in the direction of the arrow N. The light travelling in the direction N applies undesirable exposure light to the photosensitive member 120, resulting in a lowering of the resolution of the image. In this embodiment, the respective end faces 419 and 420 of the colour adjusting filter 416 and the transparent glass 417 at the junction therebetween are polished so that the rays of light for forming an image are not regularly reflected by the end faces of the filter 416 and glass 417.

The regular reflection caused by the end faces of the colour adjusting filter and the transparent glass may also, for example, be prevented by any of the following methods:-

(1) optical bonding, i.e. the respective end faces of the colour adjusting filter 416 and the transparent glass 417 are bonded together using an adhesive having a refractive index which is equal to that of the glass, whereby, since there is no change in refractive index at the junction, reflection can be prevented;

(2) painting the end faces black to absorb light rays and to thereby prevent reflection; and

(3) covering half of the transparent glass with a film having the same transmission characteristics as those of the colour adjusting filter 416. In the case where the colour adjusting filter 416 is sufficiently thin so as to have no effect on the optical path length, it is possible to ignore the quantity of light which is reflected by the end faces 419,420.

The following is a description of uniform exposure which may be achieved by the use of the apparatus according to the present invention.

The importance and the principle of the uniform exposure will first be explained.

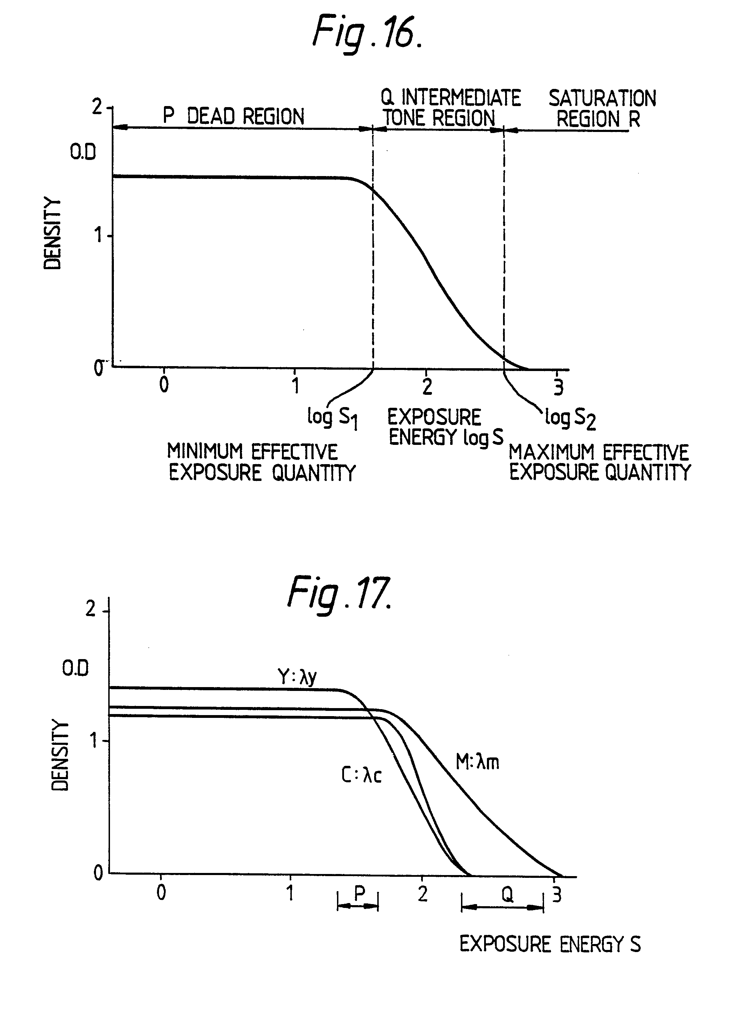

Referring to Figure 16, the range of levels of exposure energy for colour development at intermediate densities which occur in an intermediate tone region Q is relatively small. Therefore, if,for example, the overall level of exposure energy is adjusted so that the amount of exposure light for the brightest portion of the original image for exposure is located at the boundary between the intermediate tone region Q and a saturation region R, the gradation of the bright portion of the image is satisfactorily reproduced. However, the amount of exposure light for the dark portion is insufficient and is within a dead region P, which means that it is impossible to reproduce the gradation of the dark portion.

Figure 17 is a graph showing the relationship between the exposure energy S and the colour development density (O.D. value) in one example of an image forming process carried out using micro-capsules containing photo-setting substances. More specifically, the above-described relationships are plotted along three characteristic curves in regard to three different kinds of micro-capsule i.e. those which are provided for yellow, magenta and cyan colours. The central photo-setting reaction generating wavelengths of the photo-setting substances contained in the three different kinds of micro-capsules are $\lambda Y$, $\lambda M$ and $\lambda C$, respectively. Assuming that in this example light rays having wavelengths $\lambda Y$, $\lambda M$ and $\lambda C$, respectively, are applied to the micro-capules with a uniform energy distribution in order to form a gray image having gradation, the following problems will occur. Namely, in the portion P which has a relatively small amount of exposure light, yellow alone is insufficiently developed and therefore the resulting image is bluish, whereas, in the portion Q which has a relatively large amount of exposure light, magenta alone is developed.

Strictly speaking, the above described two problems are experienced with silver halide photography or the like. However, in an image forming process in which a photo-setting reaction is utilized and a colour-developing reaction is caused by destruction of micro-capsules, the above described problems are particularly noticeable and lead to considerable degradation of the quality of the resulting image for the reasons that the dependence of the photo-setting reaction on wavelength is high and that intermediate tone cannot effectively be controlled in accordance with the degree of destruction of the micro-capsules. These problems may be overcome by carrying out the uniform exposure which is a feature of the present invention.

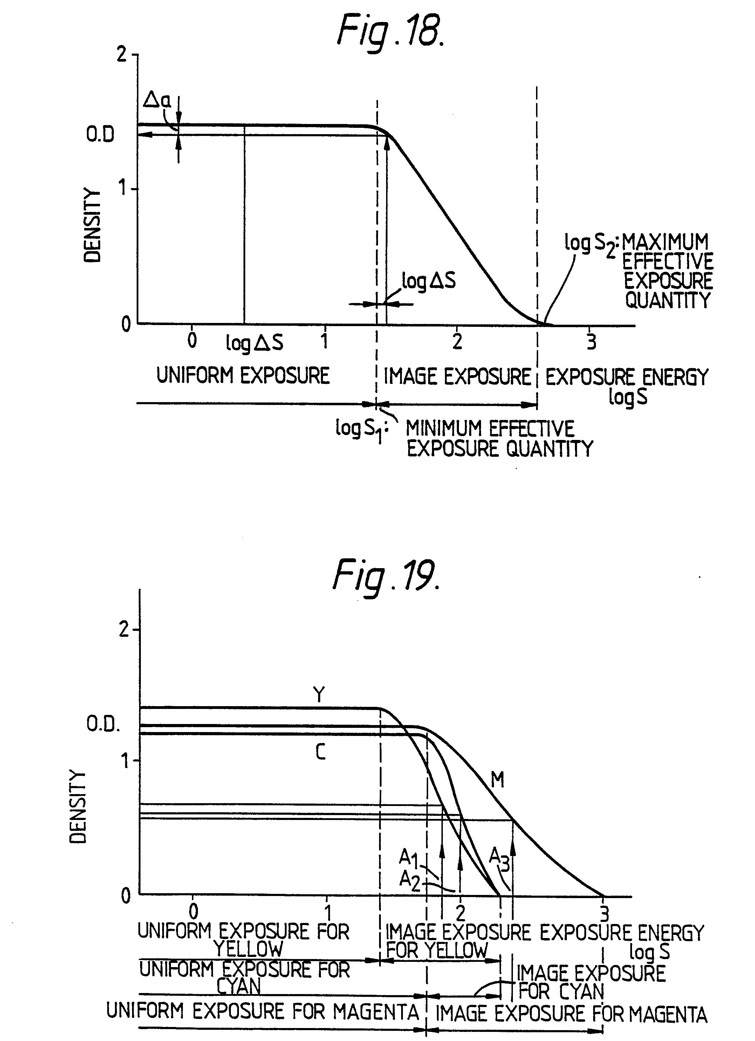

Referring to Figure 18, a photosensitive member which has a minimum effective exposure quantity S1 and a maximum effective exposure quantity S2 is subjected to a uniform exposure with the exposure quantity S1 and is then further subjected to image exposure in such a way that the exposure quantity for the brightest portion of the image is S2-S1. By so doing, even if the image exposure quantity $\Delta S$ is very small, it appears as a change in density on the image which is indicated by $\Delta a$ in the figure, so that it is possible to obtain an image having excellently reproduced intermediate tone.

The following is a description of the uniform exoposure in the case where a colour image is formed.

Referring to Figure 19, in the case of a colour image, the uniform exposure is carried out by an amount corresponding to the minimum effective exposure quantity for each of the colours, e.g. yellow, magenta and cyan. As to the image exposure also, an exposure quantity for each colour is set so that the sum of the uniform exposure quantity for the colour concerned and the image exposure quantity of the brightest portion of a particular image is equal to the maximum effective exposure quantity for the colour. Assuming that exposure is carried out with half (on the logarithmic scale basis) the maximum value of the image exposure quantity for each colour to obtain a gray image, the three colours are developed substantially uniformly as shown by the arrows A1, A2, and A3 in the figure. Thus, it is possible to obtain a gray image having excellently reproduced tone.

There is an upper limit to the time that the effectiveness of the uniform exposure lasts. In other words, the period of time within which the effectiveness of the above-described uniform exposure can be maintained is relatively short. This is attributed to the fact that the light energy absorbed in that portion of the photosensitive member 120 where the setting or softening of the micro-capsules 502 has not yet started, that is, an amount of light energy which corresponds to the necessary and minimum exposure quantity, is being gradually released from said portion from the time when the light energy is applied thereto.

For example, in the case where the image exposure is carried out after the completion of the uniform exposure process, if the period of time which begins at the time of completion of the uniform exposure to the time when the image exposure is effected and pressure development is carried out is excessively long, the above-described excellent intermediate tone and colour tone reproducibilities may be lost.

For this reason, it may be arranged that the period of time from the completion of the uniform exposure to the start of the pressure development is minimized as described below.

One particular embodiment of the present invention in which such uniform exposure is achieved will next be explained.

Referring to Figure 2, the uniform exposure optical system 260 consists of a slit 261 provided in the reflector 212, a colour compensating filter 263 for the uniform exposure, and a diaphragm 265 which is slidable, through the action of a feed roller 264 on a casing member 216. The feed roller 264 has its shaft (not shown) extending through the side plate of the outer casing so as to project to the outside, so that the diaphragm 265 can be moved in the directions of the arrow I shown in the figure by rotating the shaft to thereby change the uniform exposure quantity.

In this embodiment, the direct light from the halogen lamp 211 is obtained through the slit 261 as a light source for the uniform exposure As the colour compensating filter 263, a single kind of absorption type glass filter may be employed which has well-balanced characteristics so that a correct exposure quantity is obtained with respect to each of the three different kinds of micro-capsule, i.e. those which are provided for the yellow, magenta and cyan colours. Accordingly, when the uniform exposure quantity is changed by means of the diaphragm 265, the exposure quantity with respect to the micro-capsules for all the three colours, i.e. yellow, magenta and cyan, is changed.

Thus, it is possible to obtain an image of high quality which has excellently reproduced intermediate tone. However, strictly speaking, there is a possibility that an image of excellent quality cannot be obtained due to variations of the individual parts of the apparatus and changes in environmental conditions such as temperature and humidity.

If it is desired to make strict adjustment and with the above-described factors taken into consideration, the following arrangement may be effective. Namely, three slits are provided in the casing member 216, and three different kinds of filter, e.g. red, green and blue filters, are disposed in the respective slits, and further a diaphragm is provided for each of the filters. Thus, it is possible to control the above-described colour tone reproducibility delicately and precisely.

To cope with variations in the uniform exposure quantity due to changes in temperature and humidity, it is also possible to automatically control the uniform exoposure quantity by providing means for detecting temperature and humidity.

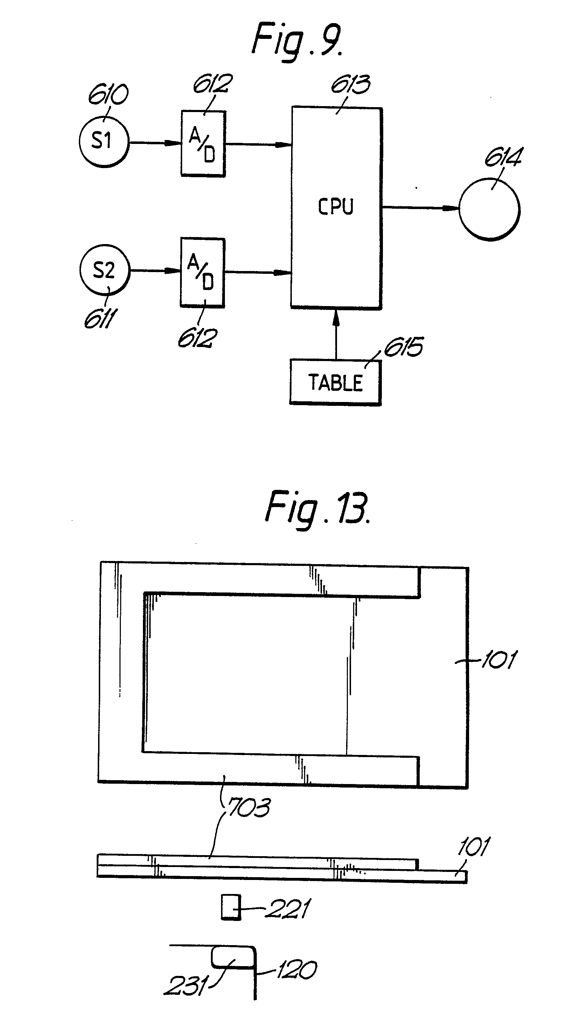

Figure 9 is a schematic block diagram of one example of a control system for effecting the above-described control of the uniform exposure quantity. In this control system, signals from a temperature sensor 610 and a humidity sensor 611 which are disposed in the vicinity of the photosensitive member 120 are converted into digital signals in respective analogue-digital signal processing circuits 612, and these digital signals are inputted to a central processing unit (CPU) 613. The CPU 613 refers to a preset constant table 615 in accordance with these input signals to thereby send an appropriate driving signal to a motor 614 which opens or closes the diaphragm means for controlling the uniform exposure quantity.

Still another example of a uniform exposure system will next be explained.

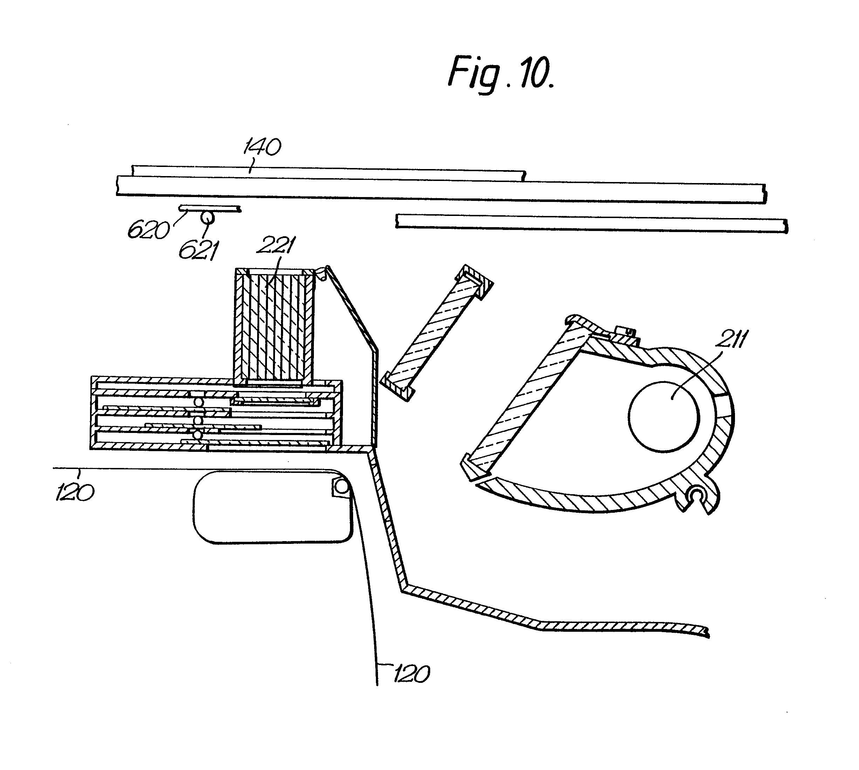

Figure 10 is a schematic sectional view of a uniform exposure system in accordance with this example in which, in a copying machine, the reflected light from the halogen lamp 211 is employed as a light source for the uniform exposure.

The uniform exposure means in this example consists of a reflecting plate 620 whose surface that faces the self-focusing lens group 221 is substantially white, and a feed roller 621. The light for illumination which is emitted from the halogen lamp 211 irradiates not only the original 140 but also the white surface of the reflecting plate 620 in the same manner. Thus, the self-focusing lens group 221 projects not only the image of the original 140 but also the image of the reflecting plate 620 on the photosensitive member 120, thus effecting the uniform exposure. Since, however, the reflecting plate 620 is not disposed at the focal point of the lens group 221, the image of the reflecting plate 620 is out of focus. The feed roller 621 can be rotated from the outside in the same manner as in the case of the above-described feed roller 264, so that it is possible to adjust the uniform exposure quantity by advancing or withdrawing the reflecting plate 620 with respect to the self-focusing lens group 221.

It is, of course, also possible to obtain the same advantageous effect by providing a light source for the uniform exposure separately from the halogen lamp 211.

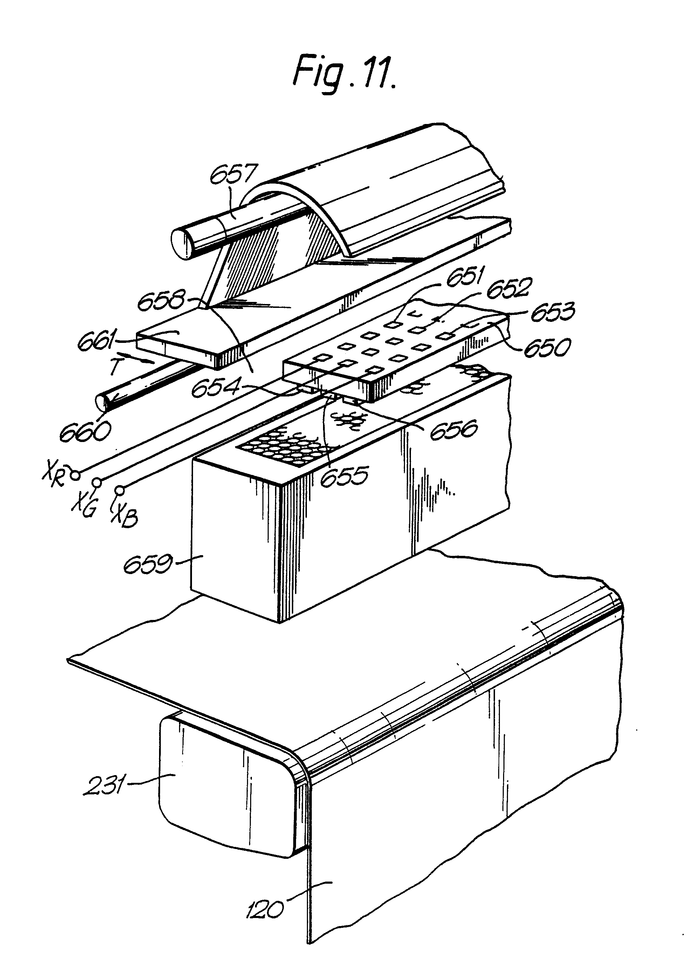

Figure 11 shows a further example of a uniform exposure system according to the present invention. In this example, the present invention is applied to an image forming apparatus of the type in which an image is recorded on a photosensitive member by controlling the light transmitting condition in accordance with an electrical signal which represents image information.

Pieces of information $X_R$, $X_G$ and $X_B$ concerning red, green and blue, respectively, are applied in the form of voltages to micro-shutter arrays 651, 652 and 653 which are arranged in a liquid crystal valve 650, so that the respective transmittances of the micro-shutter arrays 651, 652 and 653 change in accordance with the applied voltages. Red, green and blue filters 654, 655 and 656 are provided for the micro-shutter arrays 651, 652 and 653 to which are applied the pieces of image information $X_R$, $X_G$ and $X_B$. The light emitted from a halogen lamp 657 is partially applied to the liquid crystal light valve 650, and a part of the light from the lamp 657 passes through a slit 658 for the uniform exposure. In the same manner as in the case of the foregoing examples, a self-focusing lens group 659 projects the images of the micro-shutter arrays 651, 652 and 653 onto the photosensitive member 120, and pieces of image information are given to the micro-shutter arrays 651, 652 and 653 in correspondence to the speed at which the photosensitive member 120 is advanced over the exposure plate 231, thus enabling an image to be recorded on the photosensitive member 120. The uniform exposure quantity can be changed by means of a diaphragm 661 which can be moved in the directions of the arrows T in Figure 11 by rotating a feed roller 660 in the same manner as in the foregoing examples.

In this example, the photosensitive member 120 is scanned with exposure light in the shape of a slit by the self-focusing lens group 659 to thereby obtain an image, and within several seconds after the completion of the image exposure process, the photosensitive member 120 is transported in the direction of the arrow J in Figure 2 to receive uniform exposure light through the slit 658. The time interval from the above-described image exposure process for scanning exposure to the uniform exposure process is fixed for any position on the image. Accordingly, the effectiveness of the uniform exposure is not lost at substantially any position of the image.

The following is a description of a means for solving the above-mentioned problem that it is desirable to prevent unnecessary colour development from occurring outside the image forming region so that the contour of the image forming region is not blurred. In apparatus described herein, the above-described problem may be solved by exposing those photo-setting substances on the photosensitive member which are out of the image forming region to thereby set said substances. This embodiment will next be explained.

The embodiment shown in Figure 2 is arranged such that the leading and trailing edge portions of an image which are out of the image forming region are exposed in order to set the micro-capsules on the photosensitive member 120 which are located in the corresponding regions, thus causing the corresponding regions on the transfer member 130 to become white.

In this embodiment, exposure of the unnecessary regions is effected by the use of the reflected light from the halogen lamp 211 which is a main light source for image exposure.

It is first assumed that a plurality of duplicate copies of a single original are to be taken continuously. When the copying operation is started, the original plate 101 moves in the direction F" from the stand-by position shown in Figure 2 by an amount corresponding to the size of the transfer member 130, so that the leading edge portion of the original 140 reaches a position where it can be illuminated with the halogen lamp 211. Then, the original plate 101 moves in the direction of the arrow F', and the whole of the original 140, i.e. from the leading edge portion to the trailing edge portion, is thereby illuminated with the light from the halogen lamp 211. Thus, the photosensitive member 120 is exposed by the reflected light from the original 140. At this time, the photosensitive member 120 is exposed from a region thereof which is contiguous with that region which has already been exposed by white light in accordance with the method described later. After the trailing edge portion of the original 140 has been illuminated, the white plate 291 is subsequently illuminated. The white plate 291 is defined by a plate painted white which is made of a metal such as iron or aluminium or is made from a resin material. The length $\ell$, of the white plate 291 is only required to be double the margin required to form an edge for one edge portion of the transfer member 130. The visible light reflected from the white plate 291 becomes white light which passes through the self-focusing lens group 221 to expose the photosensitive member 120. Since white light includes all the colours, i.e. yellow, magenta and cyan, the white light applied to the photosensitive member 120 causes all the micro-capsules applied thereto to set. Accordingly, substantially all the capsules in that region on the photosensitive member 120 which corresponds to the leading edge portion of the transfer member 130 are caused to harden by exposure to light.

The exposed photosensitive member 120 is fed into the pressure developing means 300 in the following sequence, that is, the region first exposed by the white light, the region exposed by the reflected light from the original 140, and the region exposed to the white light from the white plate 291. The exposed photosensitive member 120 is laid on the transfer member 130 and subjected to pressure development in the pressure developing means 300. At this time, the leading edge portion of the transfer member 130 is first edged with white. Subsequently, the image is transferred to the transfer member 130, and then the trailing edge portion of the transfer member 130 is edged with white.

Accordingly, white edges are clearly formed at the leading and trailing edge portions of the transfer member 130 despite the above-described operation of the intermediate press roller 302 to hold and release the transfer member 130. On the other hand the length $l_1$ of the white plate 291 is double the margin required to form an edge for one edge portion of the transfer member 130, and therefore after the trailing edge portion of one transfer member 130 has been edged, the leading edge portion of a subsequent transfer member 130 is successively edged. Repetition of the above-described process enables realization of the following advantageous operation. Namely, the leading edge portion of each of the transfer members 130 which are successively fed into the pressure developing means 300 is laid on that region of the photosensitive member 120 where substantially all the micro-capsules have already become set and these members are pressed. Therefore, no liquid component contained in the capsules flows out to adhere to the photosensitive member 120. Accordingly, it is possible to readily separate the transfer member 130 from the photosensitive member 120.

Next, it is assumed that, after one original has been copied, another original is to be copied after a given time. By the scanning of the white plate 291 carried out subsequently to the scanning of the first original 140, that region of the photosensitive member 120 which corresponds to the leading edge portion of the subsequent transfer member 130 has already been exposed by white light. Therefore, the photosensitive member 120 is started to be exposed by the reflected light from the original 140 from the region thereof which is contiguous with the already-exposed region and then exposed by white light. Accordingly, substantially all the micro-capsules in those regions of the photosensitive member 120 which respectively correspond to the leading and trailing edge portions of the transfer member 130 are caused to set by the light exposure. When this exposed photosensitive member 120 is laid on the transfer member 130 and subjected to pressure development, the leading edge portion of the transfer member 130 is first edged with white. Subsequently, the image is transferred to the transfer member 130, and then the trailing edge portion of the transfer member 130 is edged with white. At this time, the transport of the photosensitive member 120 is suspended. In the above-described development, one half of that region of the photosensitive member 120 which has been exposed to white light alone is used to edge the trailing edge portion of the transfer member 130, and the other half of the exposed region which is to be used to edge the leading edge portion of the subsequent transfer member 130, that is, the exposed portion which corresponds to a half the length $l_1$, is left unused. Accordingly, when another original is to be copied after a given time, the photosensitive member 120 is first rewound in the direction opposite to the arrow J, and the photosensitive member 120 is started to be exposed from the region thereof which is contiguous with the region already exposed by white light. As has been described above, the photosensitive member 120 is first exposed by the reflected light from the original 140 and then exposed by the white light from the white plate 291. Accordingly, substantially all the micro-capsules in those regions of the photosensitive member 120 which respectively correspond to the leading and trailing edge portions of the transfer member 130 are caused to set by the light exposure. Thus, in this case also, the above-described advantageous effects can be obtained.

Although in this embodiment the white plate 291 is provided at the left-hand side (as viewed in Figure 2) of the original 140, this is not essential. For example, the white plate 291 may be provided at the right hand side of the original 140. It is also possible to provide two white plates at both the left and right sides, respectively, of the original 140.

Although in the above-described embodiment the halogen lamp 211 which is a main light source for image exposure is employed to expose regions other than the image forming region, the light source for exposing said regions is not necessarily limited to the halogen lamp 211.

The following example employs an auxiliary light source for exposing regions other than the image forming region.

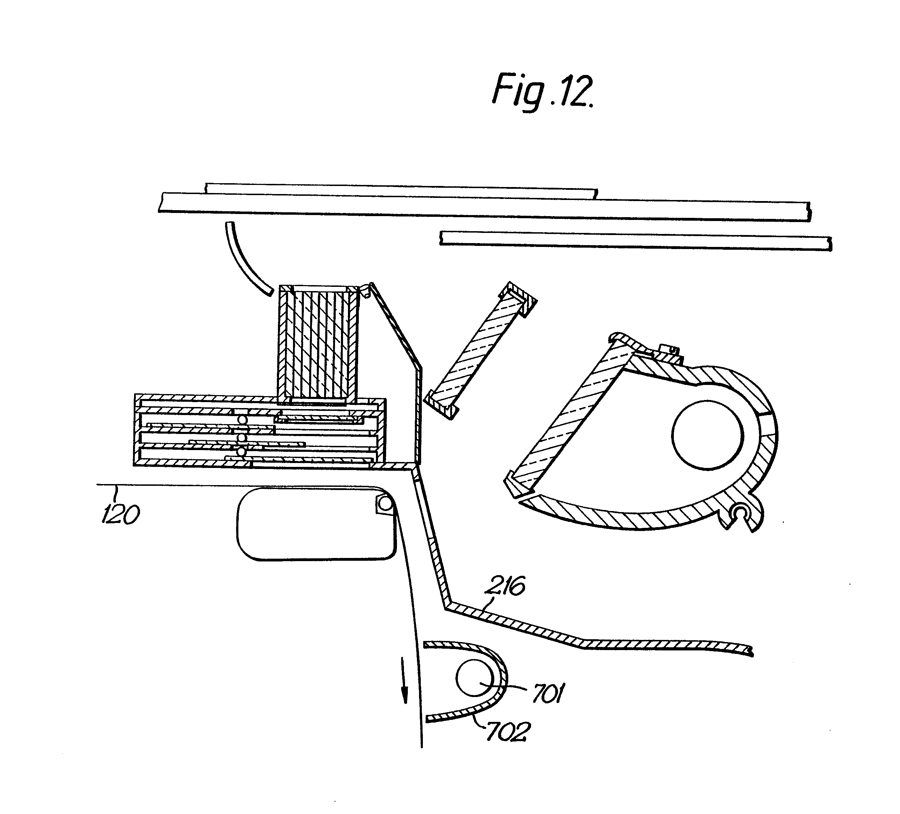

Referring to Figure 12, there are provided below the casing member 216 an auxiliary light source 701 which serves to set substantially all the micro-capsules in a predetermined region of the photosensitive member 120, and a reflector 702 which enables light rays emitted from the auxiliary light source 701 to be efficiently applied to the photosensitive member 120. In this example, a white fluorescent lamp of about 15 W which is in the shape of a straight tube is employed as the auxiliary light source 701, and the light source 701 and the reflector 702 are arranged so that regions of the photosensitive member 120 other than the image forming region are illuminated with the light from the auxiliary light source 701.

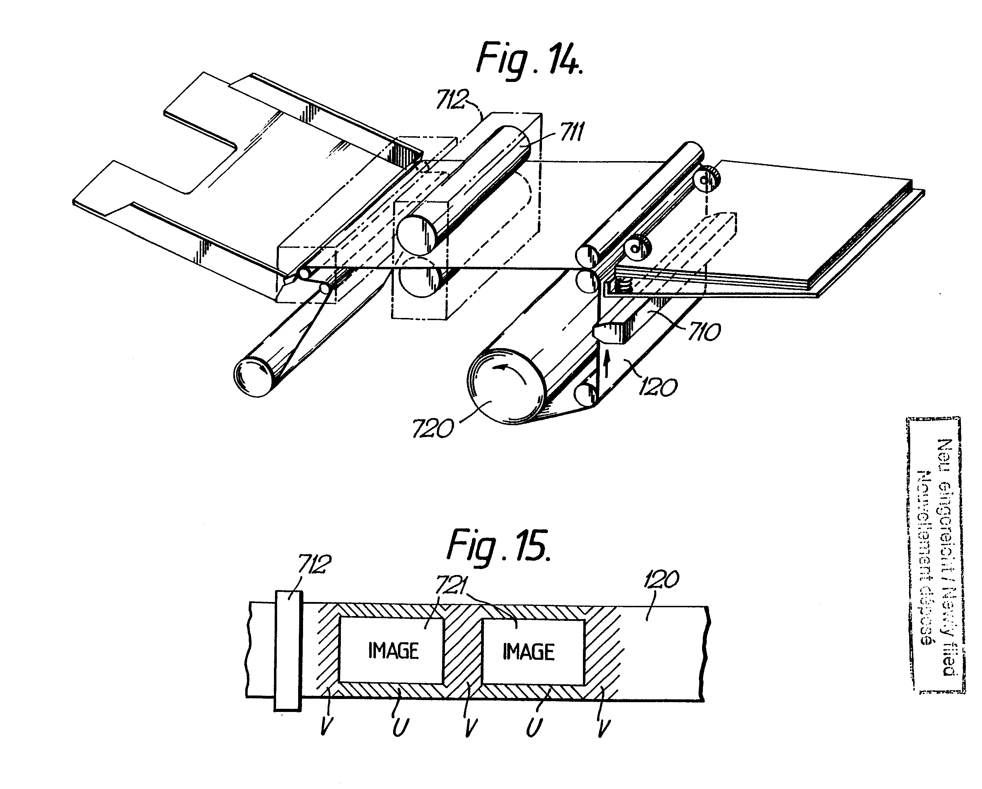

Although in the above-described example the leading and trailing edge portions of the transfer member 130 are made white, it is effective practice, in order to further improve the quality (appearance) of the resulting image and further enhance the reliability of the pressure developing means 300, to expose all the regions of the transfer member 130 which surround the image forming region. The means for achieving this will briefly be explained below with reference to Figure 13 which shows an embodiment in which the white plate 291 shown in Figure 2 is modified.

It should be noted that the upper portion of Figure 13 schematically shows the arrangement as viewed from the upper side of the original plate 101, while the lower portion of the figure is a side view of the arrangement. A white plate 703 has a U-shaped configuration so that both lateral edge portions of the photosensitive member 120 are also exposed to set the micro-capsules thereon. The other portions of the arrangement are the same as those in the above-described examples, and the operation thereof is also the same. It is also possible to attain advantageous effects which are similar to those of the above-described examples.

Figure 14 shows an example which is arranged to expose regions of the photosensitive member other than the image forming region in an image printer that employs a liquid crystal shutter array.

Referring to Figure 14, the photosensitive member 120 which is unwound from a roll 720 is moved while being subjected to exposure by means of an optical write head 710 which consists of a light source and a liquid crystal micro-shutter array which is capable of shielding the light from the light source in accordance with image data. The photosensitive member 120 consists of micro-capsules containing a photo-setting substance and a colour developing agent and a substrate for the micro-capsules. In this arrangement, the optical write head 710 is capable of exposing a wider region than the width of the photosensitive member 120. The write head 710 gives the liquid crystal micro-shutter array a signal which makes transparent the liquid crystal micro-shutters for the regions (the hatched regions U in Figure 15) of the photosensitive member 120 which are out of the image forming regions 721 and which are located at both sides of the image forming region in the direction perpendicular to the direction of advance of the photosensitive member 120, that is, the lateral edge portions of the member 120, thereby exposing the whole surfaces of the lateral edge portions. Further, the whole surface of the liquid crystal micro-shutter array is made transparent for the region (the hatched regions V in Figure 15) of the photosensitive member 120 which is subsequent to the image forming region, thereby exposing the whole surface of this region as far as the position immediately before the subsequent image forming region. Thereafter, the transfer member 130 is laid on the photosensitive member 120 and these members are pressed by a pressing means 712 for effecting pressure development using a pressure roller 711. Thus, the image is transferred to the transfer member 130 in such a way that a larger number of micro-capsules are crushed in a region which has been less exposed. However, the micro-capsules in the regions which are out of the image forming region are not crushed because these regions have sufficiently been exposed as described above. Accordingly, no unnecessary colour development occurs on the transfer member 130. Further, since those regions of the photosensitive member 120 which surround the transfer member 130 have also sufficiently been exposed, no micro-capsules are crushed in these regions when the members 120 and 130 are pressed by the pressing means 712. Accordingly, there is no fear of the contents of the micro-capsules attaching to the surface of the pressure roller 711 of the pressing means 712, and it is therefore possible to prevent the surface of the pressure roller 711 from being damaged or deteriorated.

Although in this example a combination of a light source and a liquid crystal micro-shutter array is employed as the optical write head 710, it is also possible to employ an LED array, a laser scan system or the like.

Although the present invention has been described through specific terms, it should be noted here that the described embodiments are not necessarily exclusive and various changes and modifications may be imparted thereto without departing from the scope of the invention which is limited solely by the appended claims.

## Claims

1. A photographic transfer type image forming apparatus comprising support means (114,115) for supporting a photosensitive member (120) which carries capsules (502) containing a photo-setting substance and a colour developing agent; exposure means (200), including illuminating means (210), for exposing an image forming region (721) of the photosensitive member (120) to light from an original (140) which is to be copied, so that the photosensitive member (120) is provided with a latent image in the image forming region (721); and developing means (300) for transferring the latent image to a transfer member (130) so as to form an image on the latter characterised in that the exposure means (200) comprises uniform exposure means (260) for subjecting the image forming region (721) to uniform exposure.

2. Apparatus according to claim 1 characterised in that the exposure means (200) also comprises further exposure means (291) for effecting exposure of the regions (U,V) of the photosensitive member (120) adjacent to the image forming region (721).

3. Apparatus according to claim 1 or 2 characterised in that the developing means (300) comprises means (301, 302) for effecting pressure contact between the photosensitive member (120) and the transfer member (130).

4. Apparatus according to any preceding claim, characterised in that the exposure means (200) comprises an exposure member (231) which reflects or scatters the light emitted from said illuminating means (210) when said photosensitive member (120) is being exposed.

5. Apparatus according to claim 4 characterised in that said exposure member (400) is arranged so that various portions thereof have different reflectivities or light scattering coefficients.

6. Apparatus according to any preceding claim, characterised in that the uniform exposure means (260) comprises adjustment means (265) which enables the uniform exposure quantity with respect to said photosensitive member (120) to be changed.

7. Apparatus according to any preceding claim characterised in that the uniform exposure means (260) comprises means (610,611) which enables the uniform exposure quantity to be changed in accordance with temperature and humidity.

8. Apparatus according to any preceding claim characterised in that the uniform exposure means (260) employs as light for the uniform exposure direct or indirect light emitted from said illuminating means (210).

9. Apparatus according to any of claims 1-6, characterised in that the uniform exposure means (260) employs as a light source for the uniform exposure an auxiliary light source which is used exclusively for the uniform exposure.

10. Apparatus according to claim 9, characterised in that the auxiliary light source (701) for the uniform exposure has spectral components in at least three different wavelength regions.

11. Apparatus according to any preceding claim characterised in that the uniform exposure means (260) employs a plurality of different uniform exposure quantity compensating filters (654,655,656).

12. Apparatus according to any preceding claim characterised in that the exposure means (200) has a colour adjusting means (240) which comprises a colour temperature compensating filter (243) for effecting colour temperature compensation of direct or indirect light emitted from said illuminating means (210) and colour adjusting filter means (244,245,246) for effecting colour adjustment.

13. Apparatus according to claim 11 characterised in that said colour adjusting filter means comprises three different filters (410,411,412), and further filters (417) which transmit substantially all visible rays and each of which has substantially the same thickness as that of each of the three different filters (410,411,412).

14. Apparatus according to claim 2 or any claim appendant thereto characterised in that the further exposure means (291) effects exposure using direct or indirect light emitted from said illuminating means (210).

15. Apparatus according to any preceding claim characterised in that the exposure means (200) has an auxiliary light source (701) which is exclusively used to expose a region (U,V) adjacent to the image forming region (721).

16. A photographic transfer type image forming apparatus comprising support means (114,115) for supporting a photo-sensitive member (120) which carries capsules (502) containing a photo-setting substance and a colour developing agent; exposure means (200), including illuminating means (210), for exposing an image forming region (721) of the photosensitive member (120) to light from an original (140) which is to be copied, so that the photosensitive member (120) is provided with a latent image in the image forming region (721); and developing means (300) for transferring the latent image to a transfer member (130) so as to form an image on the latter characterised in that the exposure means (200) comprises further exposure means (291) for effecting exposure of the regions (U,V) of the photosensitive member (120) adjacent to the image forming region (721).

17. A photographic transfer type image forming apparatus wherein a photosensitive member (120) having on its surface a multiplicity of micro-capsules (502) containing at least a photo-setting substance and a colour developing agent is laid on a transfer member (130) before or after image exposure and these members are pressed after image exposure to thereby effect development and fixing, characterised by comprising;

an illuminating means (210) for directly or indirectly illuminating said photosensitive member (120);

exposure means (200) for subjecting said photosensitive member (120) to image exposure, uniform exposure and exposure for a region (U,V) other than an image forming region (721); and

pressure developing means (300) for subjecting said photosensitive and transfer members (120,130) laid one upon the other to pressure development.

# Fig.1.

# Fig.2.

0 278 599

**Fig .3.**

**Fig .5.**

**Fig .6.**

**Fig .7.**

**Fig .8.**

# Fig.4.

0 278 599

## Fig.9.

610 612 613

S1 → A/D → CPU → 614

S2 → A/D →

611 612

TABLE 615

## Fig.13.

101

703

101

221

231 120

# Fig.10.

140

620
621
221
120

211

120

0 278 599

# Fig. 11.

657

658

661

T

660

$X_R$

$X_G$ $X_B$

651 652

653

650

654

656

655

659

231

120

# Fig.12.

120

216

701

702

0 278 599

Fig. 14.

712
711
710
120
720

Fig. 15.

712
721
120

IMAGE    IMAGE

V    U    V    U    V

0 278 599

## Fig.16.

P DEAD REGION     Q INTERMEDIATE TONE REGION     SATURATION REGION R

DENSITY O.D

log S$_1$    EXPOSURE ENERGY log S    log S$_2$

MINIMUM EFFECTIVE EXPOSURE QUANTITY     MAXIMUM EFFECTIVE EXPOSURE QUANTITY

## Fig.17.

DENSITY O.D

Y : λy

C : λc

M : λm

P    Q

EXPOSURE ENERGY S

*Fig.18.*

*Fig.19.*